**Europäisches Patentamt**

**European Patent Office**

**Office européen des brevets**

(19)

(11) Publication number : **0 671 836 A2**

(12) # EUROPEAN PATENT APPLICATION

(21) Application number : **95600004.6**

(22) Date of filing : **22.02.95**

(51) Int. Cl.⁶ : **H04L 25/03, H03M 13/00**

(30) Priority : **01.03.94 GR 94010109**

(43) Date of publication of application :
**13.09.95 Bulletin 95/37**

(84) Designated Contracting States :
**DE FR GB IT SE**

(71) Applicant : **INTRACOM A.E.**
**19,5 ch. th. Neas Odou Paianias Marcopoulou**
**GR-190 02 Paiania, Attica (GR)**

(72) Inventor : **Spyridon, Blionas**
**19.5 Km Markopoulou Ave**
**190 02, Peania, Attika (GR)**

(54) **Integrated circuit for maximum likelihood estimation of transmitted digital data.**

(57)    In modern data transmission systems the main reasons for the unreliable reception of data is the InterSymbol Interference (ISI), the noise together with the errors (in the demodulation stage and the timing of the samples). There is, however, a maximum likelihood receiver that minimises these effects in an optimum way, using dedicated algorithms. One well known algorithm which eliminates ISI, due to multi-path propagation, in mobile communication receivers is the Viterbi algorithm that determines the real transmitted sequence, by observing the data for a long time interval.

The Viterbi algorithm can be used not only for the decoding of convolutional code sequences but also for the estimation of the maximum likelihood sequence of data distorted by ISI.

The current patent application concerns an integrated circuit that executes a properly modified Viterbi algorithm using parallel architecture. Implementations of the Viterbi algorithm using commercial DSPs or ASICs have been reported in the past. However they do not employ a parallel architecture and thus, require much longer processing times.

The main use of the proposed invention is in the Maximum Likelihood Sequence Estimation (MLSE) of digital data sequences, distorted by noise attributed to ISI. The same architecture, however, with minor modifications, can also be used to decode digital data coded with convolutional codes.

*Figure 3*

EP 0 671 836 A2

In modern data transmission systems, the main reasons for the unreliable reception are the Intersymbol Interference (ISI), the noise, together with errors at the phase of the demodulating carrier and the timing of the sampling.

At the Digital Communications and particularly at the transmission of digital data the following phenomena often appears:

The input sequence $U_K$ of discrete time, is used to modulate a continuous waveform that will be transmitted through a channel. During the sampling at the receiver the perfect samples $Z_K$ should be identical to the corresponding ones transmitted, which, however, is not true because they are affected by the "noise" from the neighbourhood samples. The latter phenomenon is called InterSymbol Interference and causes the correlation among consecutive symbols of the data sequence.

There is, however, a receiver that minimises all these effects with a maximum likelihood technique using dedicated algorithms.

One of these algorithms, which is actually used at the receivers at mobile systems to eliminate the ISI effects caused by the multipath propagation is the Viterbi algorithm.

A Maximum Likelihood Sequence Receiver would function in an adaptive mode so as to follow the time variations of the transmission channel in applications like the mobile telephony.

We assume that the transmitter transmits periodically sequences at time intervals called time slots.

The characteristics of the time slots (Figure 0) are the following:

Every slot consists of the left and right part of 60 bits each. The 3 first and the 3 last bits are 0 while the rest 57+57 are information. At the centre of the slot exists the preamble that is 26 bits of which the 5 first and the 5 last are known and are used for the initialisation of the Viterbi algorithm. Finally the 16 bits at the centre are information regarding the transmission channel response.

The communication system employs TDMA (Time Division Multiple Access). A total of 8 subscribers may share the channel and transmit every 5ms a slot, i.e. to have total 8 slots (frame) of duration 4,57ms, and bit-rate 270kb/s with duration of every slot 0.571ms.

Because of the previously mentioned interference of the bits, a good strategy to estimate the true transmitted data sequence, should be based on the observation of a long received sequence, and not on a symbol-by-symbol basis.

Therefore the feature of the Maximum Likelihood Sequence Estimation seems to be an appropriate solution. The Viterbi algorithm performing MLSE may be used not only for the decoding of data coded with convolutional codes but also for the estimation of the maximum likelihood sequence of data received with distortion because of the ISI.

Assuming n is the number of bits for which there exists InterSymbol Interference. If n=5, most of the situations that may appear in real operation conditions may be resolved. The total number of the possible transmitted sequences are 32 (all possible combinations of the 5 bits), which are called states.

Every state is characterised by the decimal number which represents the binary sequence of the 5 bits. The received signal by the receiver is sampled, and, for every transmitted bit, corresponds an 8-bit value which comprises the input data for the algorithm.

The Viterbi processor performs a step of the algorithm every time it receives a sample. The number of steps is equal to the number of bits which modulated the carrier to form a slot. A probability is assigned to every one of the 32 possible sequences of 5 bits. Every state is possible to have two predecessors, i.e. the state 10010 is possible to have as predecessors the 01001 or the 11001. At every step for every state $\alpha_i$ i=0...31 the predecessor state has to be determined. Therefore two probabilities (one for each predecessor) are calculated, the so called "metrics" are evaluated and the maximum of those metrics is selected.

It is obvious that at every state except of the corresponding probability there is also a history of "survivor paths" that keeps track of the transitions through all the steps of the algorithm. There are as many survivor paths as there are states. It is expected that after 15 steps the algorithm will converge and the survivor paths tend to have a common part that is called "common history path". The latter is the maximum likelihood estimate of the transmitted sequence determined by the algorithm.

This common history path has occured for previous data and not the current ones.

Thus, the algorithm makes a decision for the samples received 15 steps before, resulting in a delay that leads to a last step which decides about the last 15 transmitted bits.

The Architectures that have been presented up to now for the Viterbi algorithm refer to implementations for decoding data encoded by convolutional codes.

In the paper J. Stahl et. al. ("High Speed Viterbi Decoder", Signal Processing III Theories and applications, Vol. 2, No. 6, pp. 1117-1120, 1986), the three main parts of the architecture are the unit that produces the transition coefficients for each state, the unit that computes the new probabilities of each state (unit add-compare-choose) and finally the unit that stores the paths for each state. Each unit works on different data (pipe lining) and uses fixed point arithmetic. However this architecture refers only to decoding.

In the paper T. Ishitani et. al. ("A scarce-State-Transition Viterbi-decoder VLSI for bit error Correction", IEEE J. Solid-State Circuits, Vol. SC-22, No. 4, pp. 575-581, Aug. 1987) a unit add-compare-choose is described that refers not to the execution of the Viterbi algorithm but to a differentiated view of the SST (Scarce-State-Transition) with 3-bit received samples. There are 64 states assumed and a path length of 29, while 6 bit adders with 3 bit block lookahead are used.

As far as the Viterbi algorithm is concerned for data equalisation the presented implementations are either with DSP programming or using simple Von Neuman architecture (Blionas et. al. "ASIC Design with the BACH Behavioural Synthesis System", The European Design Automation Conference, Glasgow, Scotland Poster Session 2, March 1990).

In the paper A. Balboni et. al. ("A Special Purpose Technology independent SIMD Parallel Processor for the Viterbi Algorithm", Proc. of IFIP Workshop on Parallel Architectures on Silicon: from Systolic Arrays to Neural Networks, Grenoble France pp. 227-239, December 1989) and in the Ph.D. dissertation of S. V. Blionas ("VLSI Design for Parallel Digital Signal Processing", Dept. of Electrical Engineering, University of Patras, June 1990), a design and implementation technique for ICs is shown. This technique uses a technology and vendor independent data base and has as a pilot application a Viterbi processor that lacks in speed and parameterisation to the one presented here. The proposed patent achieves better results because it uses a special control unit and a parallel sum unit and is used only for equalisation and not for data decoding.

In a European patent application (EPO467522), an architecture is proposed for the Viterbi algorithm for data equalisation and decoding. However, this algorithm is of classical Von Neuman architecture and not parallel, as the proposed invention. Also the EPO398690 application calculates sequentially the algorithm, without any parallelism in the processing units for all quantities that the algorithm computes. The lack of parallelism disables the system to function in real time, especially in a mobile telephony environment (270 Kbits/s), where, it is expected, that the rates will quadruple over the next years.

The said integrated circuit is the only specialised monolithic integrated circuit, having parallel architecture (with parallel processors for simultaneous computation of all the algorithm's coefficients) that uses the modified Viterbi algorithm for removal of InterSymbol Interference from digital transmitted signals. It is based on the channel response and by itself may be used in real time data transmission systems (e.g. mobile telephony), even in future systems of up to 6 Mbits/sec. The same chip may decode data coded by convolutional codes.

The high operation speed of the said integrated circuit is because of the parallel architecture for the calculation not only of the basic algorithm quantities, but also of the computation of certain constants by the dedicated parallel sum unit, as well as by the control unit that permits operation of the circuit at a speed at least quadruple of the one specified by the critical path.

The above characteristics make the said integrated circuit to be the only one that can manage the needs of mobile telephony which are estimated to be in the order of a few Mbits/sec.

The description of the figures that follow simply consist a realisation of the invention as an example without constituting any limitation whatsoever.

Figure 0:     Description of transmitted time slots.
Figure 1:     Data transmission System of linear modulated carrier
Figure 2:     Example of an Imaginary data sequence
Figure 3:     SIMD array of processors for the Viterbi Algorithm
Figure 4:     Block Diagram of processor 0-7
Figure 5:     Block Diagram of processor 8-15
Figure 6:     Interface Unit
Figure 7:     Read procedure timing
Figure 8:     Write procedure timing
Figure 9:     Control Logic for the Accumulator
Figure 10:    Control Logic for the Real Imaginary Registers
Figure 11:    Control Unit
Figure 12:    Hold time for set and reset of a register
Figure 13:    Synchroniser circuitry
Figure 14:    Synchroniser's operation
Figure 15:    COM_DEL down counter circuitry

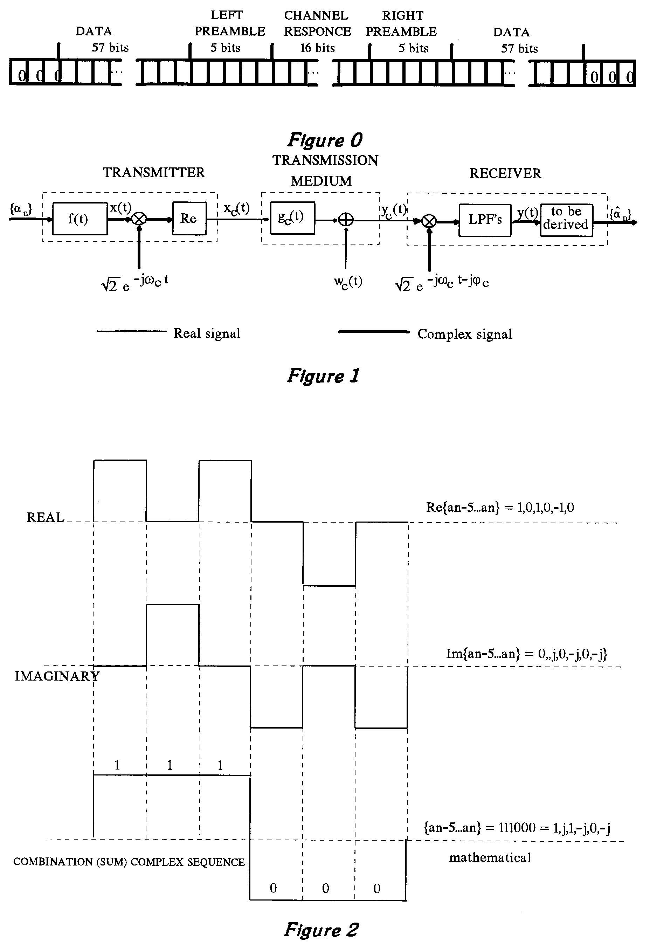

Consider a synchronous linear carrier-modulated data transmission system as shown in Fig. 1. Because of the combination of the In-phase and Quadrature components, $\{\alpha_n\}$ is a complex data sequence (heavy lines); i.e. if the data sequence $\{\alpha_{n-5} ...\alpha_n\}$=111000 and assuming that the $a_n$ bit is imaginary, the mathematical representation is 1j1-j-1-j, so for the imaginary part of the signal we have 0=-j and 1=j, while for the real part we have 0=-1 and 1=1;

The pulse amplitude modulation gives :

$$x(t)=\sum_n \alpha_n\ f(t\text{-}nT)$$

(baseband waveform) T=symbol spacing, $\alpha_n$=data,

$f(t)$ = modulated pulse shape

$x_c(t) = x(t)cos\Omega_c t$ carrier modulated waveform

Assuming a transmittion channel with the following characteristics:

$g_c(t)$ = impulse response of the channel

and

N(t) = additive white Gaussian noise, ∗ = convolution

At the receiver the following signal is received:

$$y_c(t)\ =\ g_c(t)\ *\ Re\ \{\sqrt{2}x(t)exp(j\omega_c t)\}\ +\ N(t)$$

However, the $y_c(t)$ spectrum has redundancies that can be eliminated without loss of information, using a LP Filter. The output of the LPF is:

$$y(t)=\sum_n a_n h(t\text{-}nT) + \sqrt{2}\,N(t)exp(\text{-}j\omega_c t\text{-}j\varphi_c)$$

where $h(t)=[g_c(t)exp(\text{-}j\omega_c t\text{-}j\phi_c)] * f(t) = g(t) * f(t)$.

Thus, the overall channel response changes the received waveform and y(t) contains convoluted information plus the noise which corresponds to the bandwidth of the low-pass filter (LPF).

From the received signal y(t), a sequence $\{\Delta_n\}$ must be estimated which corresponds to the original sequence $\{\alpha_n\}$.

Suppose that we have some observations $\{\alpha_n\}$, for the interval I of the transmitted sequence. The Maximum Likelihood receiver determines as the optimum estimated $\{\Delta_n\}$, the one that maximises the Likelihood function $p[y(t), t \in I \mid \{\alpha_n\}]$

Assuming that the noise at the transmission channel is additive-white-Gaussian with zero mean value and that the h(t) and the timing of the received signal are well known, then:

Noise Autocorrelation $W(\tau)=2N_oK(\tau)$ for additive-white-Gaussian noise(AWGN) $K(\tau)=\delta(\tau)$ $\Rightarrow$ $K(\tau)*K^{-1}(\tau)=\delta(\tau)$

$$p \approx exp\{\frac{1}{4N_0}\ [\ \sum_{n\,T\in I} 2Re(\overline{\alpha}_n z_n)\text{-}\sum_{i\,T\in I}(\ \sum_{k\,T\in I}\overline{\alpha}_i\,s_{i\text{-}\kappa})^*\ \alpha_k]\}$$

$$z_n\ =\ \int_I\int_I \overline{h}\,(t_1\ \text{-}\ nT)K^{-1}(t_1\ \text{-}\ t_2)y(t_2)dt_1dt_2$$

$$\overline{s}_{\text{-}1}=s_1 = \int_I\int_I \overline{h}\,(t_1\text{-}iT)K^{-1}\,(t_1\text{-}t_2)h(t_2\text{-}kT)dt_1dt_2$$
$$l=k\text{-}i$$

$z_n$, $s_l$ are outputs from the matched filter (MF) with $g_{MF}(t)=\overline{h(\text{-}t)} * K^{-1}(t)$

$N_o$ = two-sides spectral density, but

$G_{MF}(f) = \dfrac{\overline{H}(f)}{K(f)}$ $G_{MF}(f)$, $H(f)$, and $K(f)$ the Fourier Transform of $g_{MF}(t)$, $H(t)$, and $K(t)$ respectively.

This means that $g_{MF}(t)$ exists if the PSD of the noise is always non zero. The MF maximises SNR but ISI still exists. The Viterbi algorithm is used to remove ISI caused by the multipath propagation. The maximum likelihood sequence estimator (MLSE) selects the appropriate $\Delta_n$, which maximises the value of the following metric:

$$\mathbf{J_I}\ (\{\alpha_I\}\ ) = \sum_{n\,T\in I} 2Re(\overline{\alpha}_n z_n)\ \text{-}\sum_{iT\in I}\ \sum_{kT\in I}\overline{\alpha}_i s_{i\text{-}k}\alpha_k \qquad \text{-A-}$$

EP 0 671 836 A2

$z_n$ contains all relevant information about $\alpha_n$

$$z_n = \sum_l \alpha_{n-1} s_l + r_n$$

$s_l$ is assumed to be known, $R_l = E(\bar{r}_n r_{n+l}) = 2N_o s_l$
$R_l$ = Autocorrelation of the noise samples.

The proposed MLSE receiver operates in an adaptive mode in order to cope with the time varying mobile channel. Also, because of the ISI results in a correlation between adjacent symbols in a data sequence, the decision has to be based on the observation of a long received sequence, and not on a symbol-by-symbol basis.

The maximisation of expression A should be done by computing all the metrics for all the possible sequences and comparing them to decide which is the most probable (which gives the maximum metric). This is difficult because of the length and the number of all the possible sequences. It is possible to use the following expression and reduce the computational load:

$$J_n(...,\alpha_{n-1},\alpha_n) = J_{n-1}(...\alpha_{n-1}) + \text{Re}(\bar{\alpha}_n(2z_n - s_o\alpha_{n-2}\sum_{k \leq n-1} s_{n-k}\alpha_k))$$

Assuming that the Intersymbol Interference is restricted among only L consecutive samples that are part of a data sequence then:

$s_l = 0 \qquad |l| > L$

$$J_n(...,\alpha_{n-1},\alpha_n) = J_{n-1}(...,\alpha_{n-1}) + \text{Re}[\bar{\alpha}_n(2z_n - s_o\alpha_n - 2\sum_{l=1}^{L} s_l\alpha_{n-1})]$$

Notice that if we know the metric of a possible binary sequence $\{....,\alpha_{n-1}\}$, then there are only 2 possible sequences $\{....,\alpha_{n-1},\alpha_n\}$ ($\alpha_n = 0$, $\alpha_n = 1$), and we can compute the maximum likelihood using the previous formulas.

For every sequence of length L corresponds a state $\mu_j$, and we have $2^L$ such states. If we know the $\mu_j$ state and sequence $\{\alpha_{j-k}...\alpha_j\}$, then is $\mu_{j-k}$ is uniquely determined. So if:

$J_n(\sigma_n)$ = the metric for the path from $\mu_{n-L}$ to $\mu_n$ via path $\sigma_n$ where $\sigma_n = \{\alpha_{n-L+1}...\alpha_n\}$ survivor path
$\bar{J}_n(\sigma_n) = \max(J_n(\alpha_{n-L}, \alpha_{n-L+1},..., \alpha_n))$
i.e. for each state $\mu_n$ we can find the maximum likelihood sequence of length L and definitely determine the state $\mu_{n-L}$ from which $\mu_n$ was reached. Supposing that for each state there is one such sequence, we have $2^L$ likely sequences to choose from.

Then, for the next step, for each state $\mu_{n+1}$, we shall use the metrics of the previous evaluation, i.e. $J_n$ for the computation of the new metrics.

It is obvious that the path history will depend on $\sigma_n$ but the further one looks back from time n-L, the dependence of the path history on $\sigma_n$ will be weakening, so one can expect a common path history up to some time (n-L-m). This is the most likely sequence which we are looking for.

Suppose that we have a 5-bit shift register, which may contain 32 possible numbers ($2^5$). In other words these are the 32 states. If a new bit enters from the right side of the shift register we have one of the two new possible numbers (depending on the value of the shifted bit, 0 or 1). From the 32 states there are 64 transitions (example 2).

In each step each state can be reached from two different states and, the algorithm selects the one of the two states which assigns the highest metric to the final state. The history path of the selected transition will comprise of the history path of the previous state, augmented by the information bit that caused this transition. For 15 steps we keep the path history of each state renewing it in every step . After a few steps we can notice that the 32 path histories have a common part in the beginning which is called "common path history" and of course, it corresponds to a unique binary sequence, viz. the detected one.

The inputs to the Viterbi algorithm are the values $s_l$ and $z_n$.
The initial conditions are:
- L=5 and we will use only the $s_1$, $s_2$, $s_3$, $s_4$, $s_5$.
- $\bar{\alpha}_n s_o \alpha_n = \bar{s}_o s_o$ is always common for all metrics and so may be ignored.

5

● Dividing all metrics by two (2) :

$$[\overline{J}_n(\sigma_n)]/2 = \text{Re}(\overline{\alpha}_n z_n) + \max_{\{\sigma_{n-1}\} \to \sigma_n} [\overline{J}_{n-1}(\sigma_{n-1})/2 - \text{Re}(\overline{\alpha}_n \sum_{l=1}^{L} s_l \alpha_{n-l})]$$

thus, the shift for the multiplication by two can be avoided.

● The master processor which will control the Viterbi chip (coprocessor) and will give the state to which corresponds to the maximum metric 1024 decimal when all other metric have value 0).

● At every step n of the algorithm there exists information regarding $a_n$ being real or imaginary bit. Every two steps the complex values of $s_l$ may change. The Viterbi chip should store the path history of every state and after 15 elaborations, it will chose using majority logic the first of the last 15 bits of all the 32 paths. The output should be the total number of 0's or 1's, whatever is the majority, otherwise the number of bits of the minority up to the 60th elaboration.

● Next it has to select the likelihood path of the 8 (0,4,8,..28) states and to output the corresponding 15 bits sequence of one of the 32 total states.

● $s_l$ and $z_n$ are complex numbers with both parts of 8 bits (real and imaginary), but only the imaginary part of $s_1$, $s_3$, $s_5$ and the real part of $s_2$ and $s_4$ will be used (it can be proven from the computation of

$$\text{Re}(\overline{\alpha}_n \sum_{l=1}^{L} s_l \alpha_{n-l})$$

The proposed architecture for the integrated circuit is a **S**ingle **I**nstruction **M**ultiple **D**ata (SIMD) one. The possibility for a systolic architecture was abandoned because of the nature of the algorithm (to proceed to the next step all results of the previous must be present) and the low yield (for choosing 32 states the yield is in the order of 6%).

To execute the algorithm described above for 32 states, 16 processors are used. This array has been realised on the said integrated circuit with the following pins:

☐ 8 pins input/output data bus

☐ 3 pins input/output address bus

☐ RD and WR input pins for reading and writing respectively of the data from/to the integrated circuit

☐ IR input pin to define the mode of operation of the Viterbi processor (real or imaginary type)

☐ IP output pin, as a flag to signal if the processor is in a wait status (P=1)

☐ reset pin, which is the hardware reset of the system reset=1=active

☐ CE input pin to enable the integrated circuit (must always be CE=1)

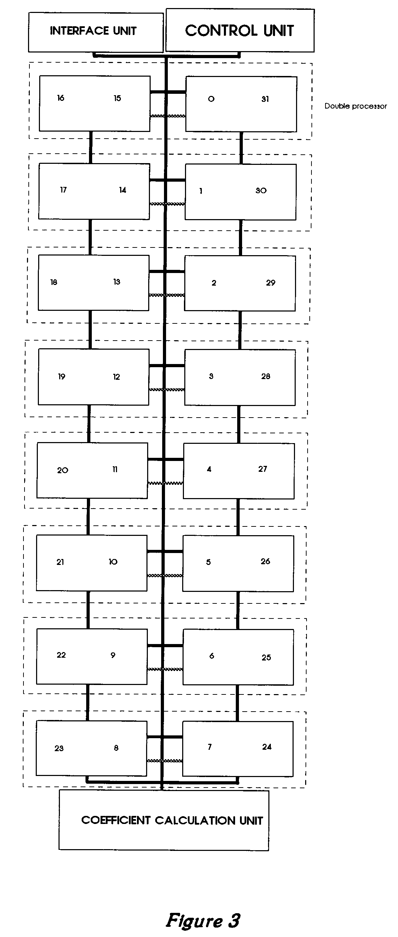

The processing elements are of two sorts which are identical except for their control signals that differ to allow each processor to perform a different function. Thus, there are 16 processors (Fig. 3), 8 "even" and 8 "odd" ones (according the state they correspond to). Assigning to each state its decimal number, as only 16 processors are used, each one computes two states. As the mapping was done by "folding" the first processor corresponds to states 0 and 31 and the last to 15 and 16.

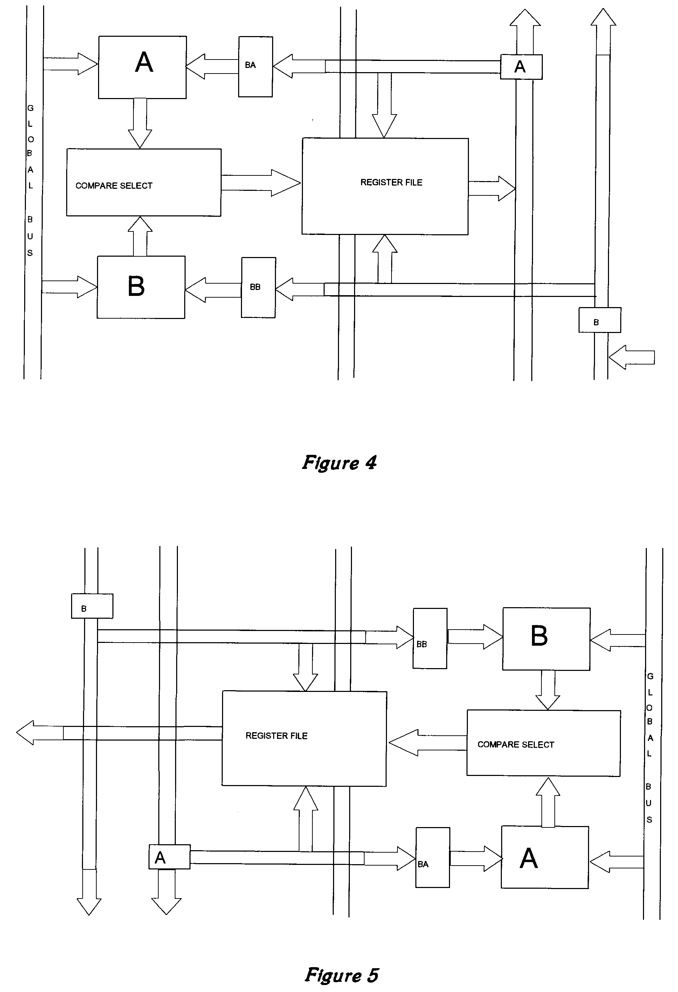

Each processor has a local memory (Fig. 4 and 5). Locally there are stored in a register file the corresponding survivor paths and the metrics of the states that each processor represent. Another difference between the elementary processors is that in the communication registers of the processors 0-7 may be stored data that reside either in the local registers or in an adjacent processor (local communications), while in processors 8-15 only data from the upper processor element can be loaded (i.e. only shifting can be performed for the delivery of the data between the processors) (Fig. 4 and 5). The local communications that needs the algorithm are such that each processor must communicate with its predecessor and with its adjacent one (Fig. 3).

Because of the local communications a dual processor was defined and an architecture with 8 identical dual processors implemented. These communicate only with the preceding and the succeeding one. The double elementary processors are depicted in Figure 3, framed by a dashed line and divided at left and right part.

The interface unit contains:

☐ address register (START-ADD, 6 bits) where the address of the ROM is stored where the first linecode starts;

☐ preamble register (PREAMB-REG, 5 bits) where are stored the first five bits of the transmitted sequence;

☐ 2 8-bit registers to keep the last 15 bits of the estimated transmitted sequence;

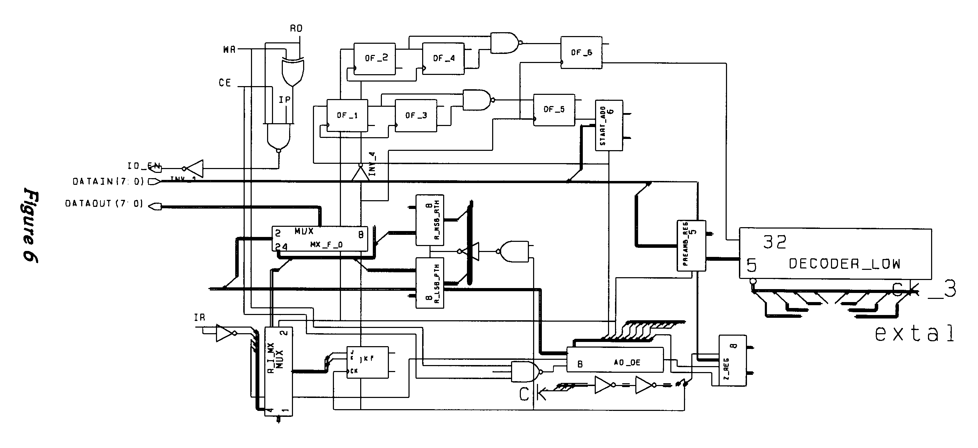

☐ 8-bit register Z-REG to record the samples for the sample to be processed. It should be noted that this register feeds a global bus that all other registers read (Fig. 6).

The communication protocol is the following:

the unit that co-operates with the Viterbi processor looks at the integrated circuit as an intermediate data bank to which it writes data and reads results.

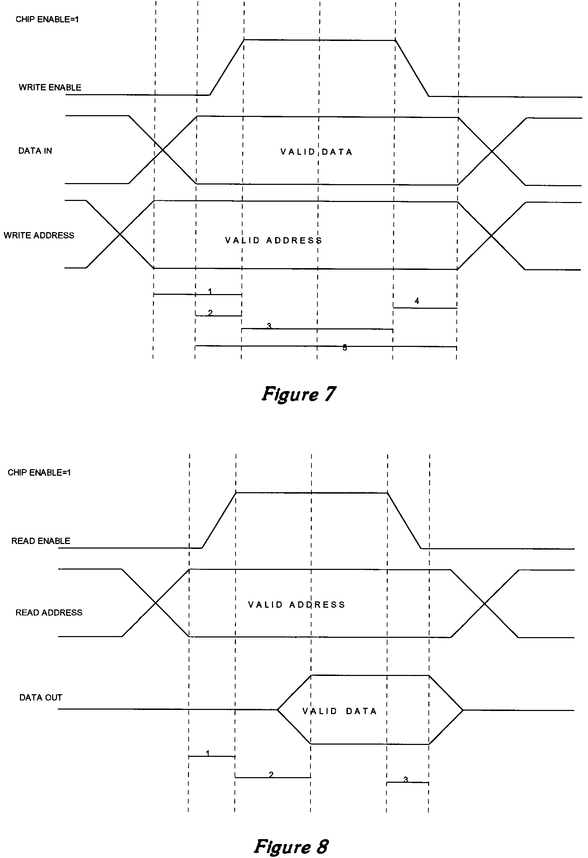

The write operation is asynchronous (Fig. 7) and has as follows (WR=1, RD=0, CE=1):

1. minimum address setup time    = 10nsec
2. minimum data setup time    = 3nsec
3. minimum write pulse duration    = 3nsec
4. minimum address data hold time    = 3nsec
5. minimum data duration time    = 3nsec

and occurs at the following addresses:

| Address | Operation |
| --- | --- |
| 000 | received sample (Z value) |
| 001 | coefficient S1 |
| 010 | coefficient S2 |
| 011 | coefficient S3 |
| 100 | coefficient S4 |
| 101 | coefficient S5 |
| 110 | Preamble |
| 111 | start address of the subroutine and GO |

The integrated circuit performs two main subroutines: the last step subroutine and the main program subroutine. The start addresses for these subroutines are:

Main program = 00,    Last step subroutine = 26.

The timing to write data to addresses from 0 to 5 is depicted in Fig. 8 and is the same to the timing of writing to a register:

1. Minimum address setup time    = 5nsec
2. Maximum data propagation delay time    = 15nsec
3. Maximum data hold time after deactivation of read pulse    = 3nsec
4. Minimum address hold time after deactivation of read pulse    = 0 nsec

It should be noted that the address bus is decoded to provide its outputs as (activating) clock signals to the registers that store the mentioned values.

To write to addresses 6 (110) and 7 (111) the duration of the write pulse must be at least equal to 2 periods of the clock since the processor should be synchronised with the master for its start of operation. The results are either of the main program (2 bits) or of the last step (16 bits). The latter are read in two phases as the bus is 8 bits wide. The addresses are as follows:

RD=1, CE=1, WR=0

| Address | OUTPUT |
| --- | --- |
| ☐ 000 | main program results |
| ☐ 001 | last step results (8 Least Significant Bits) |
| ☐ 010 | last step results (8 Most Significant Bits) |

The data-read timing is the same as in Fig. 8.

It should be noted that, to activate any operation, the CE pin must be high.

When the Viterbi processor is not in a **wait state** it cannot communicate with the master processor and is, thus, cut-off and not able to receive or submit data.

The sum unit prepares the transition metrics that will be used by the processors. It contains 5 registers of 8 bits each that store the coefficients of the channel (s1 to s5).

These registers feed with data a couple of 12 bit accumulators which compute 8 transition coefficients each. The reason for using 2 accumulators in parallel is that the preparation time of the coefficients from one accumulator lasts twice as long as the main program that the processors run.

There has been some "logic" added for the control so that by using the same control signals the operations of the second accumulator are appropriately modified. The data that are stored in the registers are loaded from the global input/output bus. The control of these registers is performed by six control lines that come directly from the address decoder in the interface unit. The outputs that feed the processors are two twelve-bit buses.

There are five control lines to this unit, which together with the value of the flag **IR** (which defines the mode of operation of the processor - real or imaginary) prepare the imaginary coefficients that will be used in the next step (when the processor operates in real mode) while in the current step the real coefficients are used that were computed in the previous step. This decreases the rate that the channel coefficients $s_1$ to $s_5$ can be

re-evaluated to one time every two steps of the algorithm. It is obvious that the operation of the two accumulators is modified because of the extra logic that has been assigned to them. In tables 1 and 2 the operation according to the control signals are described.

One of the control bits is the register write enable, which is not included in the table.

Table 1 refers to the selection of the operators, while table 2 to the type of operation. The contents of the Accumulator are called A, while the selected operand B.

It should be noted that when one of the coefficients s0, s2 or s4 is selected, then line CNTL(4) is 1. Thus when the processor is in real mode (i.e. the imaginary mode transition coefficients are prepared) the control signals of the operation are alternated via a multiplexer like the addition A+B with the subtraction operation A-B and vice versa. As for the accumulator B, this always executes the opposite operations from A either during the real or the imaginary mode of operation , except when operator s4 is chosen. The commands "load selected operator" and "B-A" are executed simultaneously on both accumulators. The above described can be seen in detail in table 2. Also while in the description of the algorithm it seems that 64 coefficients are needed, here the sum unit computes only 16. The reason is that all possible combinations between the 5 channel coefficients are 32 coefficients with 16 being opposite to the others. Thus by having the 16 coefficients the operations and modifying the operations the same results are achieved. The coefficients that are serially produced are stored in a series of 16 registers, one in each processor and connected thus as to form a double chain of shift registers. In this way only local connections are kept between processing elements and the control lines for the write operation are minimised. After the end of the main program that the array of processors executes, the appropriate coefficients are stored at each processor.

In Fig. 4 and 5 the block diagram of the single processing element ("even" and "odd" respectively) is depicted. These two processors make up the "double" processing element. The double processors are divided into two parts, left and right respectively.

Both contain two accumulators of 16 bits each and two inputs from which the operand to be accumulated is received in two's complement and in one's complement respectively. A third input feeds all the accumulators with a global coefficient that is the value of the sample to be examined each time (Z value).

Finally four pins determine the behaviour of the accumulator as control pins. This behaviour, with respect to the control pins is described in table 3. As the functions required by the accumulator are less than 8, they could be represented by 3 pins.

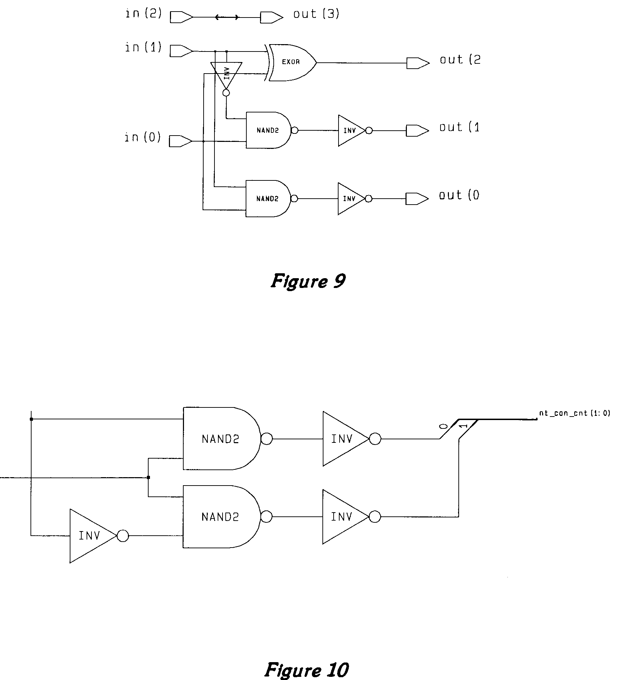

Thus these three signals come from the control unit and are decoded by a logic circuit (Fig. 9). The logic functions that are implemented, assuming as inputs a, b and c, are: $z0=a.b$, $z1=b.a$, $z2=a.b+a.b$, $z3=c$ (it should be noted that the mapping of the functions of the accumulator is not random but such that by a simple exchange of pins the opposite functions of the accumulator are performed).

Each accumulator is controlled by the signals IN(1) and IN(0), their logic complements or the same switched.

If IN is the initial control signal and $\overline{IN}$ the inverted, the mapping of the functions is such that each accumulator executes the function that corresponds for the evaluation of its corresponding state. When the global coefficient or the input operator is loaded then all accumulators execute the same function.

Externally the accumulator has the same structure as the accumulator of the Sum Unit. The operator and its inverse are the inputs of a 2-input 1-output multiplexer, of which the output makes the one of the two inputs of a 16-bit fast two's complement adder.

The second input of the adder is the output of the register which stores the result (or its inverse depending on the choice made by an internal multiplexer). The output of the adder is one of the inputs of a third multiplexer having as other inputs the input operator and the global coefficient. The output of this multiplexer is stored in the accumulator's register.

In the case of the subtraction mode content-register the complement value of the register is selected and the carry input of the accumulator is set to logic 1.

In case of overflow two cases are examined: positive and negative overflow. In both the contents of the register are maximised, positively and negatively respectively.

The reason is that in the specific algorithm the result is not important as a number but simply as a value to be compared to the other values. Care must be taken in the synchronisation of the pre-setting of the register in the maximum value, positively or negatively. During the time that the adder is preparing the result, latches are watching for any overflow. However, when the register loads the result, then in case of a positive overflow there is asynchronous pre-setting of the register to the value 7FFF, while in a negative overflow to the value 8000. It is necessary to synchronise the pre-setting with the clock because during calculations there may be spikes. The clock of the accumulator is not the same with the global distributed clock but the logical AND between it and the signal of the control unit for the activation of the register of the accumulator.

The output of the two accumulators of the processing element is the input for a magnitude comparator of two's complement numbers.

The output of this comparator controls a multiplexer to select the maximum arithmetic value as output of the unit.

The input to the accumulator is provided by the registers AC_REG which are buffers so to move data in parallel within the array of the processors, while the accumulators prepare a result.

Other registers store the values of the metrics of the algorithm which have been chosen by the comparator. Two more registers store at every step of the algorithm the survivors. These are shift registers and besides being able to load a new value they are able to shift their content to the left, while the value assigned to the least significant bit depends on the state that is represented by the specific register (even=0, odd=1).

The Real and Imag registers store the constants that the sum unit calculates which relate to the channel response through which the data are transmitted. Instead of the registers, μRAMs could be used but this would add extra decoders to the circuit for each RAM and increase of the access time, while not allowing the parallel loading of the registers Real or Imag with values corresponding to the new channel response.

The same registers exist in the right part of the double processor as well as the same arithmetic unit.

There are finally two communication registers which are the key point of this architecture. In register A any coefficient or variable of the left part can be stored, while in register B the same but for any of the right part. Additionally both of these registers can load the contents of the respective register of the previous processing element to which they are connected. The communication registers of the right part can load only the content of the previous processor of the respective registers (A or B). By this means of communications, a register chain is formed which makes up a Shift-Register. In this way the data can be transmitted from any processor to any other. This communications scheme was preferred over the direct communications because of the large area that direct interconnections would occupy on the chip and the complex communications as each register needs to be connected to more than one registers in completely different areas of the circuit. Thus direct communications would occupy the greater part of the circuit.

According to the Viterbi algorithm, from each survivor after the 15th step, the number of ones (1) has to be checked if all are 0 or 1 or else the majority has to be calculated. This is achieved by a tree-adder which in each processor consists of one-bit half adder. The two-bit outputs of these two at every processing element feed a third 2-bit adder without carry-in. This is the partial result of each processor giving the number of ones for 4 survivors. The tree-adder is ending at a five-bit adder having as output 6 bits (which is the sum of the 1 from all survivors); according to some additional logic this produces a 2-bit code signalling the decision for the transmitted bit before 15 steps. Table 4 shows the correspondence.

When ad=32 the Z1,Z2=11 when ad=0, Z1,Z2=00 if ad<=16 Z1,Z2=01 if ad>=16 Z1,Z2=10. There are also other solutions to give Z1,Z2 like a counter or a logic circuit to perform a logic function having as inputs the 32 bits of the survivors and output Z1,Z2. The reason the tree adder was chosen is that it has less hardware and is faster compared to the other solutions.

The two bits Z1, Z2 are the result of the array of the processors each time it is called to calculate data and to estimate the value of a sample. However the value of Z1, Z2 is not valid for the first 15 calls of the processor. Only after the 15th call the information is considered valid since only by then is ensured that the algorithm already has converged and there would be a common result from all 32 survivors, i.e. 00 or 11 (common path). Of course the read result after the 15th call, i.e. at the end of the 16th call, will relate to the value that was received by the processor during the 1st call. This is achieved by the 16-bit shift register that stored the survivor after each call and shifts its previous content by one position to the left, while the information is written to the right at the Least Significant Bit. Thus, for the result to be able to reach to the left (most significant bit) there have 16 calls to be made. To cover this delay one of the survivors will be given as a final result for the last 15 bits to the main processor that calls the Viterbi.

Through a process, to be explained in the next paragraph and is concerned with the data flow, the maximum likelihood survivor from the 32 is stored in the communication register of the right part of the 8th (last) double processor. The 15 bits are written in 2 registers (A-LSB-PTH and A-MSB-PTH) of 8 bits each to be able to feed the input/output bus after the call of the last step (Fig. 6). Then a multiplexer (MX-F-O) controlled by the address pins, outputs the first or the second part of the final survivor. This multiplexer is also the one that leads to the output the results Z1, Z2 during the normal calls of the integrated circuit in question.

Finally in each double processor there is a 1-bit register whose input is connected to the output of the previous while the first in the row has as input a logic 0. Thus an 8-bit shift register is formed which is used as a mask register for the moving of data.

This shifter has asynchronous setting while its clock is controlled by the same logic that controls the clock of the communication registers A.

Thus if the pre-setting pin is set, all are set to 1. Then after the circuit operates for 8 clock pulses the results of Table 5 appear.

Many inverters have been used to buffer the lines, which due to the Single Instruction Multiple Data architecture have to feed a large number of inputs. Thus in the circuit each output has a maximum fan-out of 4.

In the metrics registers there are two additional inputs which are needed for their pre-setting before the first call (by the master) of the chip.

The first 5 bits that are transmitted are called preamble and are loaded in a 5-bit register (PREAMB-REG) (Fig. 6), before any data processing starts. This register is located in the interface unit and loads this value that is provided by the master at address ad=110.

Simultaneously with the writing, at the address 110 is enabled the JK Flip-Flop that keeps the mode of operation of the Viterbi Processor. The inputs of the JK Flip-Flop are given from a 2 bits multiplexer. The inputs of the latter are 1 bit from the Control Unit duplicated as the first choice and the external input IR and its complementary is the other choice.

When no write operation takes place at address 110, the inputs of the JK are the duplicated wire from the Control Unit and functions as a T Flip-Flop. When the J and K inputs are low the JK keeps the previous value, if is high it toggles to the complementary value.

If data is written to address 110 then it is written the value applied to external pin IR. Simultaneously the preamble is written and after a delay of a clock cycle the metric registers are preset to their initial values. This circuit is a couple of Flip-Flops, and a latch. The delay is due to ensure that the right data is written to the preamble register.

The metrics registers are 15 Flip-Flops with an asynchronous clear input. (the 10th Flip-Flop that stores the 10th bit of a metric has an additional preset input). The clear inputs are activated during the writing to address 110, when the preset from the 32 bits "active low decoder with enable" (AD-DE, Figure 6).

This decoder when the enable is low all outputs are set at 1. Its input is the output of the preamble register. When the enable is active only one output that corresponds to the value of its input goes at 0.

The metric register connected to that output is preset to the decimal value 1024 (since the 10th bit is 1 and all others 0s). It is prevented with a NAND gate to have active both reset and preset inputs. After writing to address 110 all metric registers have value 0 and only one the value 1024.

It is ensured that first the preamble register is written and only when its output is stable the decoder's enable is activated to reset and preset accurately the Flip-Flops of the metric registers.

The registers Real Imaginary are enabled by the Sum Unit by a wire of the Control Unit that in combination with the operation mode of the processor IR (Real or Imaginary), activate for writing the proper chain of registers. The logic functions $C \cdot IR$ and $C \cdot \overline{IR}$, are the enable for the imaginary and real registers respectively (Figure 10).

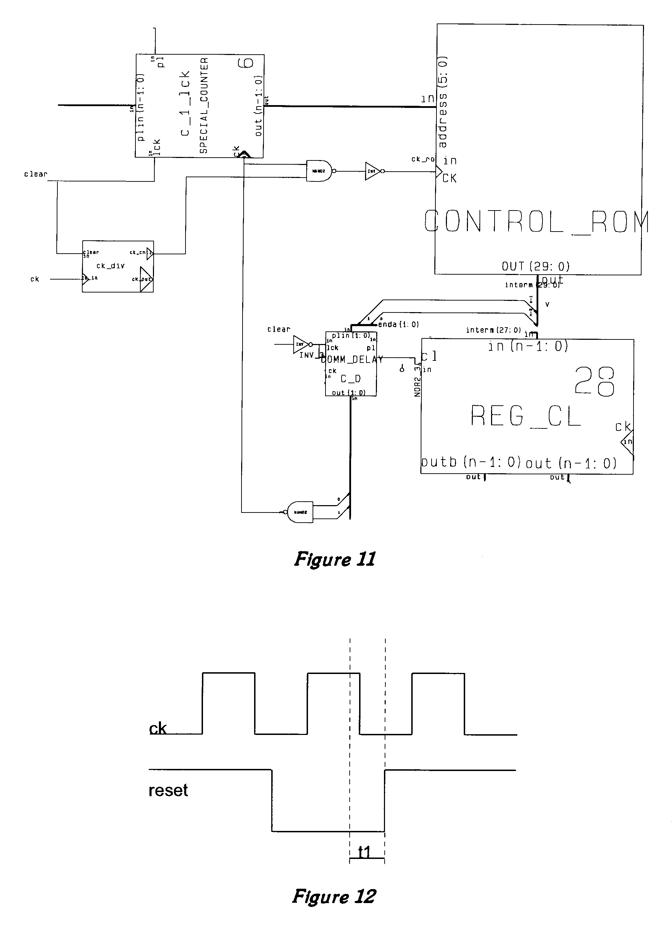

The control Unit consists of a Read Only Memory (128 words, 30 bits wide ROM), (Figure 11), with an enable pin (if it is high, the value from the input bus "address(5:0)", is latched and when it is low, outputs the data at bus OUT(30:1) after a certain delay T_delROM =24ns for the 1.0 μm standard cell technology used for the implementation of that chip.

The address of the ROM is generated by a presetable linear feedback counter of 7 bits with a lock input. It consists of 6 D Flip-Flops connected in series and a JK Flip-Flop that is the Least Significant Bit (LSB). The complementary output of this JK FF is the input of the Most Significant Bit (MSB) D Flip-Flop.

All Flip-Flops have asynchronous set and reset inputs. The states through which the counter goes is a standard sequence and not ascending numbers. The state FF(HEX) is not accessible and only activating the lock pin of the counter or pre-setting the counter to that value is possible to access it. The counter is possible to escape from that "trap" state (wait status) only by pre-setting it to another value and the it follows its normal state flow.

The wait status is used by the Viterbi processor when it is idle and waits the master to give data for processing. When this happens actually the preset pin "prst" of the program counter is set to 1 and the value at the bus start_address (connected to the preset input bus of the counter), is written asynchronously. This asynchronously writing is achieved by simple logic which activates the set or reset input accordingly to if it is 1 or 0 at the wires of the preset input bus.

The data written to the program counter is the content of the start_reg register of the interface Unit and corresponds to the address of the ROM where the first word of the code to be executed is located. The start_reg register is written asynchronously and in the address 111 by the master processor, and after a certain delay the prst pin of the program counter is activated to latch the starting address of the routine. The writing is done according to the timing restrictions (setup and hold of set and reset, Figure 12, t1 = hold for set and reset).

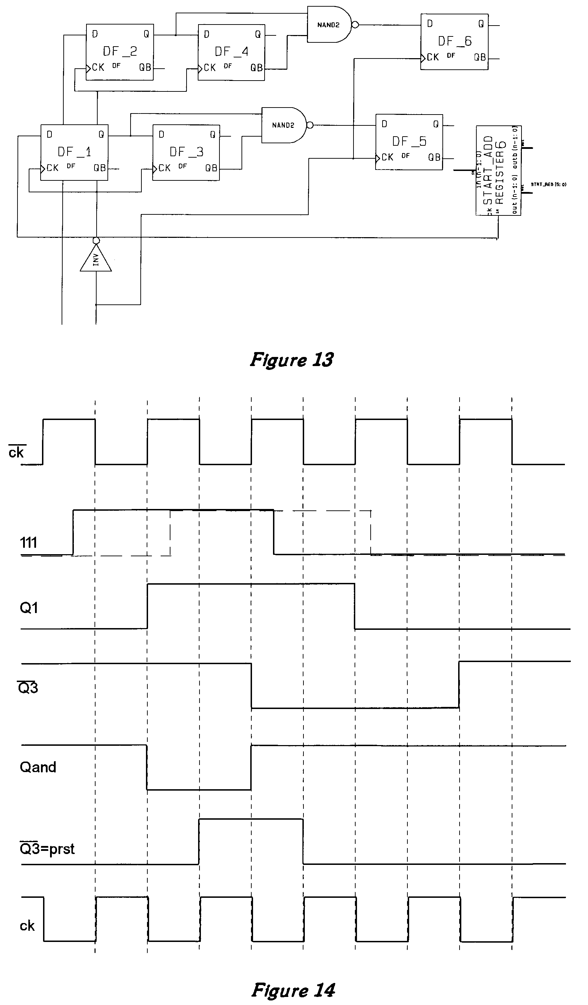

This synchronisation is achieved by the synchroniser of Figure 13 which functions as it is described in figure 14. There are three Flip-Flops (DF_1, DF_3 and DF_5).

The two first are clocked by the inverse of the Global clock $\overline{CK}$ when the third one DF_5 by the normal clock. The gate NAND2 that has inputs the output of the DF_1 and DF_3 feeds the input of DF_5.

When a rising edge arrives (when is activated) then with a delay at most of one clock cycle a positive pulse of a maximum duration T/2 appears at the output Q5. So it is ensured that during the asynchronous preset of the program counter all the timing restrictions will be respected. Also during the preset of the metrics registers it is foreseen to have the output of the preamble_reg stable because the preset of the metric registers is done from T/2 to 3T/2 before the pulse prst appears.

After the start address is written the program counter starts generating the addresses of the program code until it finds the code line which is the return command which returns the program counter to the wait status and the processor remains idle. This is achieved by activating the input of asynchronous preset of the counter to the state "all ones (FF)". The LSB bit of the data of the ROM with the hardware reset of the entire chip are inputs to a NOR2 gate the output of which is connected to the set input of the program counter. Any of both when they are high the program counter is set to FF.

The control Unit has also another counter that is used to adjust the time-length of every code line. Every command is characterised from its "time-length" that is from 1 to 4 maximum clock cycles. A couple of bits into the ROM store this information that at every linecode presets asynchronously the down counter COMM_DELAY.

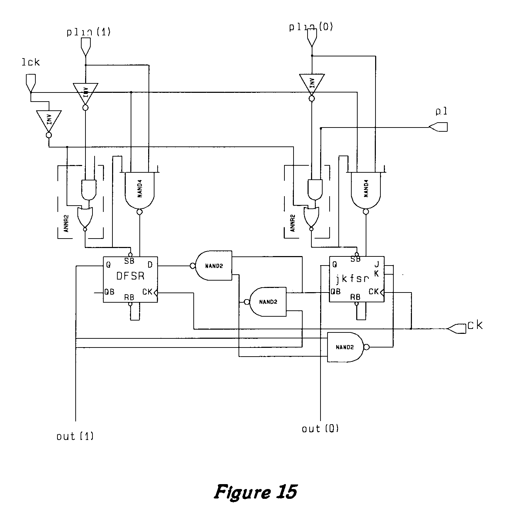

Its circuitry is described into Figure 15. It consists of a D-Flip-Flop and a JK Flip-Flop, the complementary output of which is the input of the D-FF. Both have asynchronous set and reset inputs (set, reset). There is a dedicated logic to avoid synchronous activation of both inputs. This might happen because these inputs are direct from the ROM without first to be latched (they correspond to the "time-length" of the current command). The hardware reset, presets comm_delay to 11.

The output of COMM-DELAY controls through gates the clock of the program counter and puts it to the next state as soon as the number of the pulses and counts the COMM_DELAY is the time length of the command.

Proper delays of T/2 or T are realised using latches or Flip-Flops respectively to preset asynchronously the comm_delay and to load the command register.

The subroutine of the normal step of the Viterbi algorithm some operations could take longer than a period (comparison and selection or addition). In these cases the time length of the command may be increased so to achieve the correct operation.

This is an advantage to the circuit because the control ROM clock could be increased and avoid the critical paths of the complex parts of the circuit to limit the maximum operating frequency. Also in case that a command should be repeated in consecutive clock cycles we just put the number of repetitions on the time length of the command and using just one word of the ROM to have multiple execution (Shift operation in the communication registers). The address of each command at the output of the program counter appears one clock before its loaded to the command register the proper content of the ROM. The 30 pins of the ROM, the 11, 7 and 26 (they control the loading of the Real-Imag registers and the accumulators of the Sum Unit and of the Processing elements), are activated during the last pulse of a command of duration more than one clock cycle.

There follow the Tables that refer to the above text and help to the understanding of the current embodiment of the invention.

| ADDRESS CNTL(4:2) | SELECTED VARIABLE |
| --- | --- |
| 000 | Constant 0 |
| 001 | A/2 |
| 010 | S1 |
| 011 | S3 |
| 100 | S0 |
| 101 | S2 |
| 110 | S4 |
| 111 | S4 |

Table 1: Addresses of selection for the variables of the Accumulator in Sum Unit.

| CNTL(1:0) | IR | CNTL(4) | CNTL(3) | AccumA | AccumB |
|---|---|---|---|---|---|
| 00 | x | x | x | Load of the | selected coefficient |
| 01 | 1 | x | x | $A_A + B$ | $A_B - B$ |
| 10 | 1 | x | x | $A_A + B$ | $A_B + B$ |
| 11 | x | x | x | $B - A_A$ | $B - A_B$ |
| 01 | 0 | 0 | x | $A_A + B$ | $A_B - B$ |
| 10 | 0 | 0 | x | $A_A - B$ | $A_B + B$ |
| 01 | x | 1 | 1 | $A_A - B$ | $A_B - B$ when $S_4$ is selected |
| 10 | x | 1 | 1 | $A_A + B$ | $A_B + B$ |
| 01 | 0 | 1 | 0 | $A_A - B$ | $A_B + B$ when $S_o$ or $S_2$ is selected |
| 10 | 0 | 1 | 0 | $A_A + B$ | $A_B - B$ |

Table 2: Control signals and corresponding operations at the Accumulators of the Processing elements.

| INPUT IN(2:0) | OUTPUT OUT(3:0) | OPERATION |
|---|---|---|
| 000 | 00XX | Load of the "global" coefficient |
| 001 | 01XX | Load of the input register |
| 010 | 01XX | Load of the input register |
| 011 | 00XX | Load of the "global" coefficient |
| 100 | 1X00 | Accumulator + Input |
| 101 | 1X10 | Accumulator - Input |
| 110 | 1X00 | Accumulator + Input |
| 111 | 1X01 | Input - Accumulator |

Table 3: Control Signals of the Processing elements Accumulators

| ADDER RESULTS | | | $Z_1,Z_2$ |
|---|---|---|---|
| ad(5)+ad(4)-ad(0) | ad(5) | ad(4) | |
| 1 | x | x | 00 |
| x | 1 | x | 11 |
| x | x | 1 | 01 |
| 0 | 0 | 0 | 10 |
| Table 4 | | | |

| ck | a(7:0) |
|---|---|
| 1 | 11111111 |
| 2 | 01111111 |
| 3 | 00111111 |
| 4 | 00011111 |
| 5 | 00001111 |
| 6 | 00000111 |
| 7 | 00000011 |
| 8 | 00000001 |

Table 5: Data Flow at the mask register.

## Claims

1. Integrated circuit implemented on the surface of a semiconductor material having a parallel architecture of a Single Instruction Multiple Data type, that accepts in Real time, transmitted sequences of Data, runs the modified Viterbi algorithm, estimates the maximum likelihood transmitted sequence using the information of the transmission channel response and is characterised by:

   Central Control Unit comprising a non volatile memory which keeps the algorithm code, program counter for address generation, counter to adjust the time length of a command and other glue logic.

   Interface Unit that communicates asynchronously or synchronously to receive data necessary for the execution of the algorithm, and to output the results of the processing as well as for the initialisation of the claimed integrated circuit.

   on chip coprocessor that calculates indermediate coefficients to be used by the Viterbi algorithm using the information of the transmission channel response,

   A plurality (at least two) of processing elements arranged on the semiconductor material, forming an array and running in parallel according to the instructions that feeds the said Control Unit, they exchange data locally or even not (every one with its next and/or its previous and/or its besides according the array structure),, every processing element embodies accumulators, comparators, multiplexers, registers, and/or other glue logic components.

2. The said integrated circuit of claim 1 function assuming that in the transmission channel the data interference is among 2 to 10 consecutive digital data sequence samples.

3. The said integrated circuit of claim 1, 2 characterised by it requires from 2 to 25 samples of the transmitted data sequence to output the first result concerning the first bit of the said data sequence.

4. The said integrated circuit of claim 1, 2 and 3 characterised by it may use any combination of the choices mentioned at claims 2 and 3.

5. Integrated circuit implemented on the surface of a semiconductor material having a parallel architecture of a Single Instruction Multiple Data type, that accepts in Real time, transmitted sequences of Data, coded with convolutional codes, runs the modified Viterbi algorithm, estimates the maximum likelihood transmitted sequence using the information of the transmission channel response, then executes the Viterbi algorithm and decodes the data using the information about the code which encoded the data, and is characterised by:

Central Control Unit including the algorithm code in a non volatile memory, program counter for address generation, counter to adjust the time length of a command and other glue logic.

Interface Unit that communicates asynchronously or synchronously to receive data necessary for the execution of the algorithm, and to output the results of the processing as well as for the initialisation of the claimed integrated circuit.

on chip coprocessor that calculates the intermediate coefficients to be used by the Viterbi algorithm using the information of the transmission channel response,

A plurality (at least two) of processing elements arranged on the semiconductor material by means of an array or random and running in parallel according to the instructions that feeds the said Control Unit, they exchange data locally or even not (every one with its next and/or its previous and/or its besides according the array structure),, every processing element embodies accumulators, comparators, multiplexers, registers, and/or other glue logic components.

6. The said integrated circuit of claim 5 function assuming that in the transmission channel the data interference is among 2 to 10 consecutive digital data sequence samples.

7. The said integrated circuit of claim 5, 6 characterised by it requires from 2 to 25 samples of the transmitted data sequence to output the first result concerning the first bit of the said data sequence.

8. The said integrated circuit of claim 5, 6 and 7 characterised by it may use any combination of the choices mentioned at claims 2 and 3.

| DATA | LEFT PREAMBLE | CHANNEL RESPONCE | RIGHT PREAMBLE | DATA |
| --- | --- | --- | --- | --- |
| 57 bits | 5 bits | 16 bits | 5 bits | 57 bits |

**Figure 0**

TRANSMITTER    TRANSMISSION MEDIUM    RECEIVER

$$\{\alpha_n\} \rightarrow \boxed{f(t)} \xrightarrow{x(t)} \otimes \rightarrow \boxed{Re} \xrightarrow{x_c(t)} \boxed{g_c(t)} \rightarrow \oplus \xrightarrow{y_c(t)} \otimes \rightarrow \boxed{LPF's} \xrightarrow{y(t)} \boxed{\substack{to\ be\\ derived}} \rightarrow \{\hat{\alpha}_n\}$$

$$\sqrt{2}\ e^{-j\omega_c t} \qquad w_c(t) \qquad \sqrt{2}\ e^{-j\omega_c t - j\varphi_c}$$

———— Real signal          ———— Complex signal

**Figure 1**

REAL          $Re\{a_{n-5}...a_n\} = 1,0,1,0,-1,0$

IMAGINARY          $Im\{a_{n-5}...a_n\} = 0,,j,0,-j,0,-j\}$

1   1   1

COMBINATION (SUM) COMPLEX SEQUENCE          $\{a_{n-5}...a_n\} = 111000 = 1,j,1,-j,0,-j$

mathematical

0   0   0

**Figure 2**

15

| INTERFACE UNIT | CONTROL UNIT |

| 16    15 | 0    31 |

Double processor

| 17    14 | 1    30 |

| 18    13 | 2    29 |

| 19    12 | 3    28 |

| 20    11 | 4    27 |

| 21    10 | 5    26 |

| 22    9 | 6    25 |

| 23    8 | 7    24 |

COEFFICIENT CALCULATION UNIT

*Figure 3*

16

**Figure 4**

**Figure 5**

*Figure 6*

**Figure 7**

**Figure 8**

in (2) ▷──────↔──────▷ out (3)

in (1) ▷

EXOR ──────▷ out (2

INV

NAND2 ──── INV ─▷ out (1

in (0) ▷

NAND2 ──── INV ─▷ out (0

*Figure 9*

NAND2 ──── INV ──────  nt_con_cnt (1:0)

INV

NAND2 ──── INV

*Figure 10*

*Figure 11*

*Figure 12*

*Figure 13*

*Figure 14*

*Figure 15*